# EUROPEAN PATENT APPLICATION

(11) **EP 4 822 364 A1**
(43) Date of publication of application: **14.10.2026**
(21) Application number: 24923225.7
(22) Date of filing: 31.07.2024
(51) Int. Cl.: G01R 31/12, G01R 31/36

(54) **INSULATION DETECTION METHOD AND APPARATUS FOR ENERGY STORAGE SYSTEM, DEVICE, MEDIUM, AND PROGRAM PRODUCT**

(30) Priority: 05.02.2024 CN 202410166666
(71) Applicant: Contemporary Amperex Technology Co., Limited, Ningde, Fujian 352100 (CN)
(72) Inventor: LI, Xin, Ningde, Fujian 352100 (CN)
(74) Representative: Lorenz Seidler Gossel Part. mbB
(86) International application number: PCT/CN2024/108876
(87) International publication number: WO 2025/167010

(57) **Abstract**

An insulation detection method and apparatus for an energy storage system, a device, a medium, and a program product. The method comprises: acquiring an insulation resistance value of each battery cluster in an energy storage system; on the basis of the insulation resistance value of each battery cluster, determining insulation information of each battery cluster, the insulation information comprising whether an insulation fault is present, as well as a fault level under when an insulation fault is present; and, on the basis of the insulation information of each battery cluster, determining insulation information of the energy storage system. The described detection method and apparatus, the device, the medium, and the program product can improve the safety and stability of an energy storage system.

## Description

### CROSS-REFERENCE

The present application references Chinese Patent Application No. 202410166666.8, filed on February 5, 2024, entitled "INSULATION DETECTION METHOD AND APPARATUS FOR ENERGY STORAGE SYSTEM, DEVICE, MEDIUM, AND PROGRAM PRODUCT", the entire content of which is incorporated herein by reference.

### TECHNICAL FIELD

The present application relates to the technical field of energy storage systems, and in particular, to an insulation detection method and apparatus for an energy storage system, a device, a medium, and a program product.

### BACKGROUND

With the development of new energy technologies, the construction of large-scale energy storage system projects is increasing. Such energy storage systems commonly employ a system solution where multiple battery clusters are connected in parallel to share a common DC bus. As the scale of parallel-connected clusters in an energy storage system increases, the system insulation condition becomes more complex. The system insulation value is a very important parameter, which affects system safety, stability, and the safety of operating personnel. Therefore, how to perform insulation detection for an energy storage system has become an urgent problem to be solved.

### SUMMARY OF THE INVENTION

Based on the aforementioned problems, the present application provides an insulation detection method and apparatus for an energy storage system, a device, a medium, and a program product, which can improve the safety and stability of the energy storage system and ensure the safety of operating personnel.

In a first aspect, the present application provides an insulation detection method for an energy storage system. The method includes: acquiring an insulation resistance value of each of battery clusters in the energy storage system; determining insulation information of each of the battery clusters according to the insulation resistance value of each of the battery clusters, the insulation information including whether an insulation fault exists and, in a case where an insulation fault exists, a fault level; and determining insulation information of the energy storage system according to the insulation information of the battery clusters.

The technical solution of the embodiments of the present application can be applied in various stages of an energy storage system, which can not only improve the safety and stability of the energy storage system, but also ensure the safety of operating personnel.

In some embodiments, the determining insulation information of the battery cluster according to the insulation resistance value of the battery cluster includes: searching, from a plurality of candidate fault intervals, for a target fault interval matching the insulation resistance value of the battery cluster; determining, in a case where the target fault interval is found, the insulation information of the battery cluster according to the fault level corresponding to the target fault interval; or determining, in a case where the target fault interval is not found, that the battery cluster has no insulation fault. The technical solution of the embodiments of the present application can quickly and accurately determine, according to the insulation resistance value and the candidate fault intervals, whether an insulation fault exists in a battery cluster and, in a case where an insulation fault exists, a fault level, thereby providing a basis for determining the insulation information of the entire energy storage system.

In some embodiments, the determining insulation information of the energy storage system according to the insulation information of the battery clusters includes: determining the insulation information of the energy storage system according to a stage in which the energy storage system is located and the insulation information of at least one of the battery clusters. The technical solution of the embodiments of the present application, when determining the insulation information, considers the stage in which the energy storage system is located, which can make the insulation detection result more accurate, thereby helping operating personnel to take protection measures more suitable for the state of the energy storage system.

In some embodiments, the determining the insulation information of the energy storage system according to a stage in which the energy storage system is located and the insulation information of at least one of the battery clusters includes: determining, after the energy storage system is powered on at high voltage, the insulation information of the energy storage system according to the insulation information of at least one of the battery clusters that has been powered on; and determining, after the energy storage system is powered off at high voltage, the insulation information of the energy storage system according to the insulation information of all battery clusters in the energy storage system. The technical solution of the embodiments of the present application fully considers that the battery clusters to be counted are different in the two scenarios of high-voltage power-on and high-voltage power-off, thereby accurately determining the insulation information of the energy storage system in these two stages. This provides a basis for subsequently taking protection measures more suitable for the state of the energy storage system, thereby improving the safety and stability of the energy storage system.

In some embodiments, the acquiring an insulation resistance value of each of battery clusters in the energy storage system includes: controlling, after the energy storage system is powered on at high voltage, an insulation detection circuit corresponding to each of the battery clusters in a time-sharing manner to perform insulation detection to obtain the insulation resistance value of each of the battery clusters. The technical solution of the embodiments of the present application can precisely detect the insulation resistance value of each battery cluster during the operation of the energy storage system, avoiding the influence on the insulation detection result by other battery clusters connected to that battery cluster, thereby improving the reliability of insulation detection. Furthermore, through this reliability, the safety of the energy storage system can be enhanced, thereby reducing the risk of endangering the safety of on-site operation and maintenance personnel due to the influence of other battery clusters.

In some embodiments, the acquiring an insulation resistance value of each of battery clusters in the energy storage system includes: after the energy storage system is powered on at high voltage, if a target battery cluster among a plurality of battery clusters is faulty, acquiring a state of the insulation detection circuit corresponding to the target battery cluster; in a case where the insulation detection circuit corresponding to the target battery cluster is in an off state, controlling the target battery cluster to be powered off at high voltage, and controlling the insulation detection circuit corresponding to the target battery cluster to be turned on and perform insulation detection to obtain the insulation resistance value of the target battery cluster; or in a case where the insulation detection circuit corresponding to the target battery cluster is in an on state, controlling the insulation detection circuit corresponding to the target battery cluster in a time-sharing manner to perform insulation detection to obtain the insulation resistance value of the target battery cluster. The technical solution of the embodiments of the present application performs insulation detection according to the actual state of the insulation detection circuit in the case where the target battery cluster is faulty, which better conforms to the actual situation of the energy storage system and can protect the insulation detection circuit, thereby improving the reliability of the insulation detection circuit.

In some embodiments, the method further includes: executing a target protection strategy corresponding to the insulation information of the energy storage system, where the target protection strategy includes at least one of controlling all battery clusters in the energy storage system to execute a high-voltage power-off operation, and controlling the energy storage system to reduce operating power. The technical solution of the embodiments of the present application executes protection measures in the case where an insulation fault exists in the energy storage system, which can improve the safety and stability of the energy storage system and ensure the safety of operating personnel.

In a second aspect, the present application further provides an insulation detection apparatus for an energy storage system, including:
an insulation detection module configured to acquire an insulation resistance value of each of battery clusters in the energy storage system;
a cluster information determination module configured to determine insulation information of the battery cluster according to the insulation resistance value of the battery cluster, the insulation information including whether an insulation fault exists and, in a case where an insulation fault exists, a fault level; and
a system information determination module configured to determine insulation information of the energy storage system according to the insulation information of the battery clusters.

In a third aspect, the present application further provides a computer device including a memory and a processor, the memory storing a computer program, where the computer program, when executed by the processor, implements the method according to any one of the embodiments in the first aspect.

In a fourth aspect, the present application further provides a computer-readable storage medium having a computer program stored thereon, where the computer program, when executed by a processor, implements the method according to any one of the embodiments in the first aspect.

In a fifth aspect, the present application further provides a computer program product including a computer program, where the computer program, when executed by a processor, implements the method according to any one of the embodiments in the first aspect.

The insulation detection method and apparatus for an energy storage system, the device, the medium, and the program product described above acquire an insulation resistance value of each of battery clusters in the energy storage system; determine insulation information of each of the battery clusters according to the insulation resistance value of each of the battery clusters, the insulation information including whether an insulation fault exists and, in a case where an insulation fault exists, a fault level; and determine insulation information of the energy storage system according to the insulation information of the battery clusters. Through the embodiments of the present application, they can be applied in various stages of an energy storage system, which can not only improve the safety and stability of the energy storage system, but also ensure the safety of operating personnel.

### BRIEF DESCRIPTION OF THE DRAWINGS

Various other advantages and benefits will become apparent to those of ordinary skill in the art upon reading the following detailed description of the optional implementations. The accompanying drawings are for the purpose of illustrating the optional implementations only and are not to be considered a limitation to the present application. Moreover, in all of the accompanying drawings, the same components are indicated by the same reference numerals. In the accompanying drawings:
FIG. 1 is a schematic diagram of an application environment of an insulation detection method for an energy storage system according to an embodiment of the present application;
FIG. 2 is a schematic flowchart of an insulation detection method for an energy storage system according to an embodiment of the present application;
FIG. 3 is a schematic flowchart of a step of determining insulation information of each of battery clusters according to an embodiment of the present application;
FIG. 4 is a schematic flowchart of a step of determining an insulation resistance value of each of battery clusters according to an embodiment of the present application;
FIG. 5 is a structural block diagram of an insulation detection apparatus for an energy storage system according to an embodiment of the present application;
FIG. 6 is a structural block diagram of an insulation detection apparatus for an energy storage system according to an embodiment of the present application; and
FIG. 7 is an internal structural diagram of a computer device according to an embodiment of the present application.

### DETAILED DESCRIPTION

The embodiments of the technical solutions of the present application will be described in detail below with reference to the accompanying drawings. The following embodiments are only used to illustrate the technical solutions of the present application more clearly, and thus are only interpreted as examples, rather than used to limit the scope of protection of the present application.

Unless otherwise defined, all technical and scientific terms used herein have the same meanings as those commonly understood by those skilled in the art of the present application. The terms used herein are intended only for the purpose of describing specific embodiments and are not intended to limit the present application. The terms "including" and "having" and any variations thereof in the specification and claims of the present application and in the description of the above accompanying drawings are intended to cover non-exclusive inclusion.

In the description of the embodiments of the present application, the technical terms such as "first" and "second" are only used to distinguish between different objects, but cannot be understood as indicating or implying relative importance or implicitly indicating the number, particular order, or primary-secondary relationship of the indicated technical features. In the description of the embodiments of the present application, the meaning of "a plurality of" is two or more, unless otherwise explicitly and specifically defined.

Reference herein to an "embodiment" means that a particular feature, structure, or property described with reference to the embodiment may be included in at least one embodiment of the present application. The appearances of the phrase in various places in the specification neither necessarily refer to a same embodiment, nor are independent or alternative embodiments mutually exclusive from other embodiments. It is explicitly and implicitly understood by those skilled in the art that the embodiments described herein may be combined with other embodiments.

In the description of the embodiments of the present application, the term "and/or" is only an association relationship for describing associated objects, indicating that there may be three relationships, for example A and/or B may represent three situations: A exists alone, both A and B exist, and B exists alone. Moreover, the character "/" herein generally indicates that the context objects are in an "or" relationship.

In the description of the embodiments of the present application, the term "a plurality of" refers to two or more (including two). Similarly, "a plurality of groups" refers to two or more (including two) groups, and "a plurality of sheets" refers to two or more (including two) sheets.

In the description of the embodiments of the present application, unless otherwise expressly specified and limited, the technical terms "mount," "connect," "connection," "fix", etc. should be understood in a broad sense, such as, a fixed connection, a detachable connection, or an integral connection; a mechanical connection, or an electrical connection; directly connect, indirectly connect through an intermediate medium, an internal communication of two elements, or interaction between two elements. For those of ordinary skill in the art, the specific meanings of the aforementioned terms in the embodiments of the present application can be understood according to specific situations.

With the development of new energy technologies, the construction of large-scale energy storage system projects is increasing. Such energy storage systems commonly employ a system solution where multiple battery clusters are connected in parallel to share a common DC bus. As the scale of parallel-connected clusters in an energy storage system increases, the system insulation condition becomes more complex. The system insulation value is a very important parameter, which affects system safety, stability, and the safety of operating personnel. Therefore, how to perform insulation detection for an energy storage system has become an urgent problem to be solved.

To address the above problems, embodiments of the present application provide an insulation detection scheme for an energy storage system. This scheme first acquires an insulation resistance value of each of battery clusters in the energy storage system; then determines insulation information of the battery cluster according to the insulation resistance value of the battery cluster; and finally determines insulation information of the energy storage system according to the insulation information of the battery clusters. The insulation detection scheme provided by the embodiments of the present application can be applied in various stages of an energy storage system, which can not only improve the safety and stability of the energy storage system, but also ensure the safety of operating personnel.

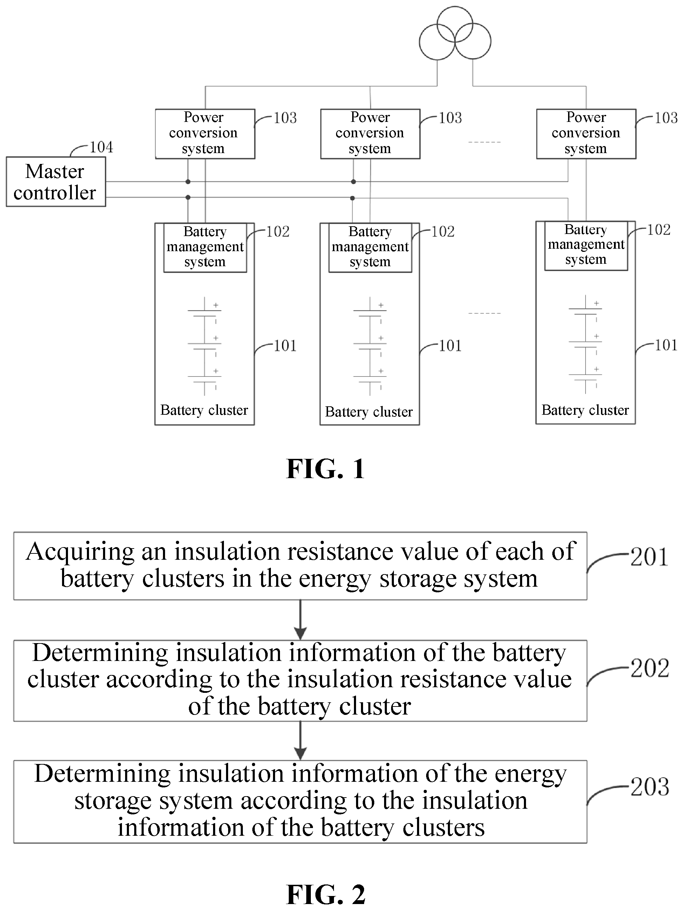

The insulation detection scheme for an energy storage system provided by the embodiments of the present application can be used in the application environment shown in FIG. 1. The application environment includes an energy storage system. The energy storage system is in a distributed architecture and includes a plurality of battery clusters 101 each formed by connecting energy storage battery packs in series, a plurality of battery management systems (BMSs) 102, a plurality of power conversion systems (PCSs) 103, and a master controller 104, where the battery clusters 101 are connected in one-to-one correspondence with the PCSs 103.

The master controller 104 is separately connected to the plurality of BMSs 102. The BMSs 102 may transmit the collected battery information to the master controller 104 and manage the battery clusters under the control of the master controller 104, for example, controlling the battery clusters to be powered on or powered off.

Each battery cluster 101 corresponds to one BMS 102. Each BMS 102 may collect battery information of the corresponding battery cluster. The battery information includes, but is not limited to, battery voltage, battery current, battery temperature, battery state of charge, etc. Each BMS 102 is provided with an insulation detection circuit. The insulation detection circuit may be connected to a main positive circuit and a main negative circuit via a relay, thereby performing insulation detection on the battery cluster. In one implementation, the master controller 104 is separately connected to the relays corresponding to the insulation detection circuits, and controls the relays to be turned on to turn on the insulation detection circuits, and controls the relays to be turned off to turn off the insulation detection circuits. In another implementation, the BMS 102 is connected to the relay corresponding to the insulation detection circuit, and the master controller 104 controls the relay to be turned on or off by controlling the BMS, thereby controlling the insulation detection circuit to be turned on or off.

The master controller 104 is also separately connected to the plurality of PCSs 103. The PCSs 103 may control, via the BMSs 102 under the control of the master controller 104, the energy storage batteries to be charged or discharged.

According to some embodiments of the present application, referring to FIG. 2, an insulation detection method for an energy storage system is provided. Taking the method being applied to the master controller of the energy storage system shown in FIG. 1 as an example for illustration, the method may include the following steps:
Step 201: acquiring an insulation resistance value of each of battery clusters in the energy storage system.

Herein, the insulation resistance value is a resistance value corresponding to the insulation resistance.

In a case where the energy storage system meets an insulation detection trigger condition, the master controller of the energy storage system controls an insulation detection circuit of a battery cluster to be detected to be turned on. The insulation detection circuit may perform insulation detection on the battery cluster under the control of the master controller; or it may automatically perform insulation detection on the battery cluster after being turned on.

The aforementioned insulation detection trigger condition may include at least one of the following: no sampling fault exists, the master controller receives a trigger operation input by a user, a current time matches an insulation detection period, and at least one of the battery clusters is faulty. Herein, the sampling fault includes invalid insulation resistance value detection, communication loss, or insulation module hardware fault, etc. It should be noted that the insulation detection trigger condition is not limited to the several ones described above and may be set according to actual situations.

The process of the insulation detection circuit performing insulation detection may include: detecting a main positive resistance value and a main negative resistance value of the battery cluster, and determining the smaller resistance value between the main positive resistance value and the main negative resistance value as the insulation resistance value of the battery cluster.

Step 202: determining insulation information of the battery cluster according to the insulation resistance value of the battery cluster. Herein, the insulation information includes whether an insulation fault exists and, in a case where an insulation fault exists, a fault level.

For each of the battery clusters, the insulation resistance value of the battery cluster may be compared with a preset threshold. If the insulation resistance value of the battery cluster is greater than the preset threshold, it indicates that the insulation resistance value is relatively large and can serve an insulation function, then it is determined that the battery cluster has no insulation fault. If the insulation resistance value of the battery cluster is less than or equal to the preset threshold, it indicates that the insulation resistance value is relatively small and may have difficulty in serving an insulation function, leading to a risk of short circuit in the energy storage system, then it is determined that the battery cluster has an insulation fault.

In one embodiment, the insulation resistance value of the battery cluster may first be compared with a first preset threshold. If the insulation resistance value of the battery cluster is greater than the first preset threshold, it is determined that the battery cluster has no insulation fault. If the insulation resistance value of the battery cluster is less than or equal to the first preset threshold, it is determined that the battery cluster has an insulation fault. In a case where it is determined that the battery cluster has an insulation fault, the insulation resistance value of the battery cluster is compared with a second preset threshold. If the insulation resistance value of the battery cluster is greater than the second preset threshold, it is determined that the fault level of the battery cluster is low; if the insulation resistance value of the battery cluster is less than or equal to the second preset threshold, it is determined that the fault level of the battery cluster is high.

Step 203: determining insulation information of the energy storage system according to the insulation information of the battery clusters.

After determining the insulation information of each of the battery clusters, the insulation information of a plurality of battery clusters is aggregated and analyzed. Based on whether an insulation fault exists in a battery cluster of the energy storage system and the fault level of the battery cluster with the insulation fault, it is determined whether the energy storage system has an insulation fault and, when the energy storage system has an insulation fault, the fault level of the energy storage system is determined, thereby obtaining the insulation information of the energy storage system.

For example, the number of battery clusters with insulation faults in the energy storage system is counted. If the number of faulty battery clusters is 0, it is determined that the energy storage system has no insulation fault; or if the number of faulty battery clusters is not 0, the fault level of the energy storage system is determined according to the number of faulty battery clusters. Furthermore, the fault levels of the faulty battery clusters may also be counted, and the fault level of the energy storage system is determined according to the number of and the fault levels of the faulty battery clusters.

It can be understood that the greater the number of faulty battery clusters, the higher the fault level of the energy storage system; and the higher the fault levels of the faulty battery clusters, the higher the fault level of the energy storage system.

In the aforementioned embodiment, the insulation resistance value of each of battery clusters in the energy storage system is acquired; the insulation information of the battery cluster is determined according to the insulation resistance value of the battery cluster; and the insulation information of the energy storage system is determined according to the insulation information of the battery clusters. The technical solution of the embodiments of the present application can be applied in various stages of an energy storage system, which can not only improve the safety and stability of the energy storage system, but also ensure the safety of operating personnel.

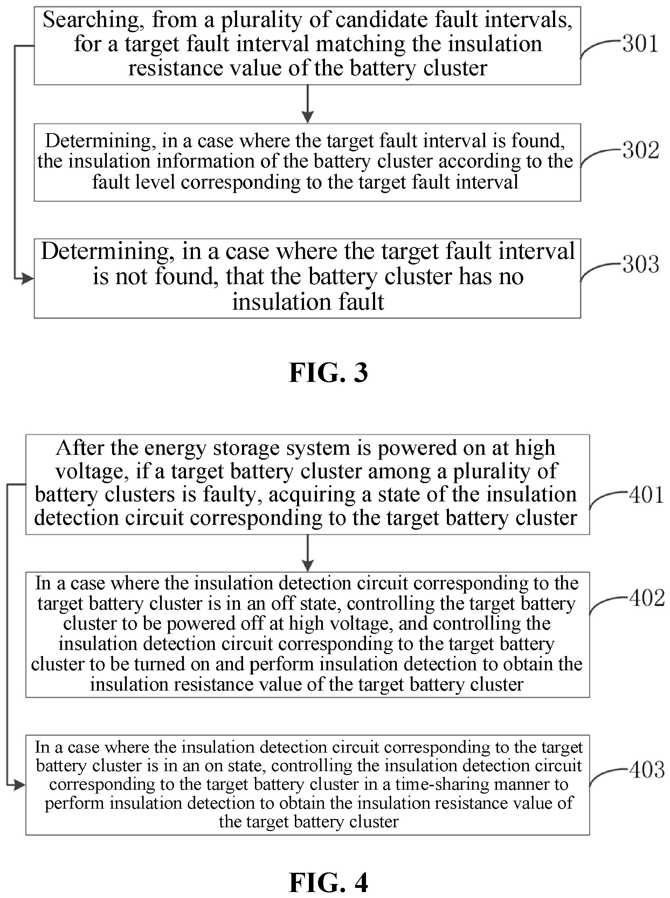

According to some embodiments of the present application, referring to FIG. 3, an implementation of the step of "determining insulation information of each of the battery clusters according to the insulation resistance value of each of the battery clusters" in the aforementioned embodiment is involved. This implementation may include the following steps:
Step 301: for each of the battery clusters, searching, from a plurality of candidate fault intervals, for a target fault interval matching the insulation resistance value of the battery cluster.

Herein, the candidate fault intervals are preset according to fault levels corresponding to different insulation resistance values. The target fault interval is the fault level among the candidate fault intervals that matches the insulation resistance value of the battery cluster.

For each of the battery clusters, based on the detected insulation resistance value, a target fault interval matching the insulation resistance value is searched for from the plurality of candidate fault intervals.

Step 302: determining, in a case where the target fault interval is found, the insulation information of the battery cluster according to the fault level corresponding to the target fault interval.

A plurality of candidate fault intervals are preset, and the candidate fault intervals correspond to the fault levels. For example, the insulation resistance value R being less than the bus voltage value * 100 Ω/V is a first candidate fault interval, and the bus voltage value * 150 Ω/V ≤ the insulation resistance value R < the bus voltage value * 750 Ω/V is a second candidate fault interval, where the first candidate fault interval corresponds to an insulation level-two fault, and the second candidate fault interval corresponds to an insulation level-one fault. Insulation faults are ranked in descending order of severity as: insulation level-two fault > insulation level-one fault > unknown insulation state > no insulation fault. Herein, the unknown insulation state indicates uncertainty about whether an insulation fault exists. No insulation fault indicates that none of the three situations-insulation level-two fault, insulation level-one fault, and unknown insulation state-has occurred.

If the target fault interval matching the insulation resistance value is found, which indicates that the battery cluster has an insulation fault, the fault level corresponding to the target fault interval is determined as the fault level of the battery cluster.

For example, if the found target fault interval is the first candidate fault interval, it indicates that the battery cluster has an insulation fault, and the fault level of the battery cluster is insulation level-two fault. If the found target fault interval is the second candidate fault interval, it indicates that the battery cluster has an insulation fault, and the fault level of the battery cluster is insulation level-one fault.

Step 303: determining, in a case where the target fault interval is not found, that the battery cluster has no insulation fault.

If the target fault interval matching the insulation resistance value is not found, it indicates that the battery cluster has no insulation fault.

In the aforementioned embodiment, a target fault interval matching the insulation resistance value of the battery cluster is searched for from a plurality of candidate fault intervals; in a case where the target fault interval is found, the insulation information of the battery cluster is determined according to the fault level corresponding to the target fault interval; or in a case where the target fault interval is not found, it is determined that the battery cluster has no insulation fault. The technical solution of the embodiments of the present application can quickly and accurately determine, according to the insulation resistance values and the candidate fault intervals, whether an insulation fault exists in a battery cluster and, in a case where an insulation fault exists, a fault level, thereby providing a basis for determining the insulation information of the entire energy storage system.

According to some embodiments of the present application, the step of "determining the insulation information of the energy storage system according to the insulation information of the plurality of battery clusters" in the aforementioned embodiment may include: determining the insulation information of the energy storage system according to a stage in which the energy storage system is located and the insulation information of at least one of the battery clusters.

The stage in which the energy storage system is located may include before high-voltage power-on, after the energy storage system is powered on at high voltage, and after the energy storage system is powered off at high voltage, etc. In different stages of the energy storage system, different insulation detection strategies may be adopted. In one implementation, in different stages of the energy storage system, the same method may be used to determine the insulation information of the energy storage system according to the insulation information of the plurality of battery clusters. For example, before the energy storage system is powered on at high voltage, after the energy storage system is powered on at high voltage, and after the energy storage system is powered off at high voltage, the same method is used to determine the insulation information of the energy storage system according to the insulation information of the plurality of battery clusters.

In another implementation, in different stages of the energy storage system, different methods may be used to determine the insulation information of the energy storage system according to the insulation information of at least one of the battery clusters. For example, in a low-voltage power-on stage of the energy storage system, a first method is used to determine the insulation information of the energy storage system according to the insulation information of at least one of the battery clusters; and after the energy storage system is powered on at high voltage and after the energy storage system is powered off at high voltage, a second method is used to determine the insulation information of the energy storage system according to the insulation information of at least one of the battery clusters.

Here, the first method may be: controlling an insulation detection circuit corresponding to each battery cluster in the energy storage system to perform insulation detection to obtain the insulation resistance value of each of battery clusters. The second method may be: controlling all insulation detection circuits to be turned off, without performing insulation detection.

In the aforementioned embodiment, the insulation information of the energy storage system is determined according to the stage in which the energy storage system is located and the insulation information of at least one of the battery clusters. The technical solution of the embodiments of the present application, when determining the insulation information, considers the stage in which the energy storage system is located, which can make the insulation detection result more accurate, thereby helping operating personnel to take protection measures more suitable for the state of the energy storage system.

According to some embodiments of the present application, the step of "determining the insulation information of the energy storage system according to a stage in which the energy storage system is located and the insulation information of at least one of the battery clusters" in the aforementioned embodiment may include: determining, after the energy storage system is powered on at high voltage, the insulation information of the energy storage system according to the insulation information of at least one of the battery clusters that has been powered on; and determining, after the energy storage system is powered off at high voltage, the insulation information of the energy storage system according to the insulation information of all battery clusters in the energy storage system.

After the energy storage system is powered on at high voltage, some battery clusters may not be powered on due to faults or other reasons. Then, insulation detection circuits corresponding to the battery clusters that have been powered on are controlled to perform insulation detection to obtain the insulation resistance values of the battery clusters that have been powered on. Then, the insulation information of the battery clusters that have been powered on is determined according to the insulation resistance values of the battery clusters that have been powered on. Afterwards, if it is determined, according to the insulation information of the battery clusters that have been powered on, that no insulation fault exists in the battery clusters that have been powered on, it is determined that the energy storage system has no insulation fault. If it is determined, according to the insulation information of the battery clusters that have been powered on, that at least one of the battery clusters that have been powered on has an insulation fault, it is determined that the energy storage system has an insulation fault.

In a case where it is determined that the energy storage system has an insulation fault, the number of faulty battery clusters may be counted, and the fault level of the energy storage system may be determined according to the number of faulty battery clusters; or the fault level of the energy storage system may be determined according to the fault levels of the faulty battery clusters. For example, the highest fault level among the faulty battery clusters is determined as the fault level of the energy storage system.

After the energy storage system is powered off at high voltage, all battery clusters in the energy storage system have been powered off. In this case, the insulation information of the energy storage system is determined according to the insulation information of all battery clusters in the energy storage system. The specific process may include: if it is determined, according to the insulation information of all battery clusters, that all battery clusters have no insulation fault, then it is determined that the energy storage system has no insulation fault. If it is determined, according to the insulation information of all battery clusters, that at least one battery cluster among all battery clusters has an insulation fault, then it is determined that the energy storage system has an insulation fault. In a case where it is determined that the energy storage system has an insulation fault, the fault level of the energy storage system may be determined with reference to the description the aforementioned embodiment.

The aforementioned high-voltage power-off of the energy storage system may be high-voltage power-off caused by an insulation fault, or high-voltage power-off based on usage requirements or on-site operation and maintenance requirements. It should be noted that the reasons for high-voltage power-off are not limited to those described above and may be set according to actual situations.

In the aforementioned embodiment, after the energy storage system is powered on at high voltage, the insulation information of the energy storage system is determined according to the insulation information of at least one of the battery clusters that has been powered on; or after the energy storage system is powered off at high voltage, the insulation information of the energy storage system is determined according to the insulation information of all battery clusters in the energy storage system. The technical solution of the embodiments of the present application fully considers that the battery clusters to be counted are different in the two scenarios of high-voltage power-on and high-voltage power-off, thereby accurately determining the insulation information of the energy storage system in these two stages. This provides a basis for subsequently taking protection measures more suitable for the state of the energy storage system, thereby improving the safety and stability of the energy storage system.

According to some embodiments of the present application, the step of "acquiring an insulation resistance value of each of battery clusters in the energy storage system" in the aforementioned embodiment may include: controlling, after the energy storage system is powered on at high voltage, an insulation detection circuit corresponding to each of the battery clusters in a time-sharing manner to perform insulation detection to obtain the insulation resistance value of each of the battery clusters.

Since two or more insulation detection circuits performing insulation detection simultaneously may cause the detected insulation resistance values to be relatively small, thus affecting the accuracy of insulation fault judgment, after the energy storage system is powered on at high voltage, time-sharing detection is performed, that is, an insulation detection circuit corresponding to one and only one battery cluster in the energy storage system is controlled to be turned on to perform insulation detection, while the insulation detection circuits corresponding to the other battery clusters are all controlled to be turned off.

In practical applications, the time-sharing detection may be performed by controlling the insulation detection circuits to perform insulation detection sequentially according to the ascending order of the serial numbers of the battery clusters; or by controlling the insulation detection circuits to perform insulation detection sequentially according to the ascending order of the numbers of detections by the insulation detection circuits; or by controlling the insulation detection circuits to perform insulation detection sequentially according to both the ascending order of the numbers of detections by the insulation detection circuits and the ascending order of the serial numbers thereof.

For example, it is determined that the numbers of detections by insulation detection circuit 1 and insulation detection circuit 2 are the same and the lowest, and the number of detections by insulation detection circuit 3 is the next lowest. Then, according to the order of the serial numbers, insulation detection circuit 1 is first controlled to perform insulation detection; then, insulation detection circuit 1 is turned off, and insulation detection circuit 2 is controlled to perform insulation detection; next, insulation detection circuit 2 is turned off, and insulation detection circuit 3 is controlled to perform insulation detection.

It can be understood that considering the lowest number of detections, it might be a newly added insulation detection circuit or a battery cluster with a relatively large number of faults. Prioritizing its detection can improve the fault identification rate, while performing insulation detection according to the order of the serial numbers facilitates observing the detection results and understanding the detection logic. It should be noted that the rules for time-sharing detection may include, but are not limited to, the numbers of detections and the serial numbers described above, and other rules may also be adopted.

In the aforementioned embodiment, after the energy storage system is powered on at high voltage, an insulation detection circuit corresponding to each of the battery clusters is controlled in a time-sharing manner to perform insulation detection to obtain the insulation resistance value of each of the battery clusters. The technical solution of the embodiments of the present application can precisely detect the insulation resistance value of each battery cluster during the operation of the energy storage system, avoiding the influence on the insulation detection result by other battery clusters connected in parallel on the AC side with that battery cluster, thereby improving the reliability of insulation detection. Furthermore, through this reliability, the safety of the energy storage system can be enhanced, thereby reducing the risk of endangering the safety of on-site operation and maintenance personnel due to the influence of other battery clusters.

According to some embodiments of the present application, referring to FIG. 4, an implementation of the step of "acquiring an insulation resistance value of each of battery clusters in the energy storage system" in the aforementioned embodiment is involved. This implementation may include the following steps:
Step 401: after the energy storage system is powered on at high voltage, if a target battery cluster among a plurality of battery clusters is faulty, acquiring a state of the insulation detection circuit corresponding to the target battery cluster.

After the energy storage system is powered on at high voltage, if a target battery cluster among a plurality of battery clusters undergoes a fault, including undergoing an insulation fault, the target battery cluster needs to be powered off at high voltage. In this case, whether the insulation detection circuit corresponding to the target battery cluster is in an off state or in an on state is first acquired.

It should be noted that the target battery cluster may be one battery cluster or multiple battery clusters.

Step 402: in a case where the insulation detection circuit corresponding to the target battery cluster is in an off state, controlling the target battery cluster to be powered off at high voltage, and controlling the insulation detection circuit corresponding to the target battery cluster to be turned on and perform insulation detection to obtain the insulation resistance value of the target battery cluster.

If the insulation detection circuit corresponding to the target battery cluster is in an off state, the target battery cluster is first controlled to be powered off at high voltage. After the target battery cluster is powered off at high voltage, the insulation detection circuit corresponding to the target battery cluster is controlled to be turned on and insulation detection is performed on the target battery cluster to obtain the insulation resistance value of the target battery cluster. After the insulation detection, the insulation detection circuit corresponding to the target battery cluster is controlled to be turned off.
Step 403: in a case where the insulation detection circuit corresponding to the target battery cluster is in an on state, controlling the insulation detection circuit corresponding to the target battery cluster in a time-sharing manner to perform insulation detection to obtain the insulation resistance value of the target battery cluster.

In some scenarios, if there is one target battery cluster that becomes faulty, insulation detection is performed on that target battery cluster. If there are a plurality of target battery clusters that become faulty, insulation detection is performed on the multiple target battery clusters in a time-sharing manner, where for the rules of time-sharing detection, reference may be made to the numbers of detections and the serial numbers described in the aforementioned embodiments, which will not be repeated in the embodiments of the present application.

In the aforementioned embodiment, after the energy storage system is powered on at high voltage, if a target battery cluster among a plurality of battery clusters is faulty, a state of the insulation detection circuit corresponding to the target battery cluster is acquired; in a case where the insulation detection circuit corresponding to the target battery cluster is in an off state, the target battery cluster is controlled to be powered off at high voltage, and the insulation detection circuit corresponding to the target battery cluster is controlled to be turned on and insulation detection is performed to obtain the insulation resistance value of the target battery cluster; or in a case where the insulation detection circuit corresponding to the target battery cluster is in an on state, the insulation detection circuit corresponding to the target battery cluster is controlled in a time-sharing manner to perform insulation detection to obtain the insulation resistance value of the target battery cluster. The technical solution of the embodiments of the present application performs insulation detection according to the actual state of the insulation detection circuit in the case where the target battery cluster is faulty, which better conforms to the actual situation of the energy storage system and can protect the insulation detection circuit, thereby improving the reliability of the insulation detection circuit.

According to some embodiments of the present application, the embodiments of the present application may further include: executing a target protection strategy corresponding to the insulation information of the energy storage system, where the target protection strategy includes at least one of controlling all battery clusters in the energy storage system to execute a high-voltage power-off operation, and controlling the energy storage system to reduce operating power.

In a case where it is determined that the energy storage system has an insulation fault, a target protection strategy is determined according to the fault level of the energy storage system, and then the target protection strategy is executed.

For example, if the fault level of the energy storage system is an insulation level-two fault, indicating that the fault level of the energy storage system is relatively high, the target protection strategy is determined to be controlling all battery clusters in the energy storage system to execute a high-voltage power-off operation, and this target protection strategy is executed. If the fault level of the energy storage system is an insulation level-one fault, indicating that the fault level of the energy storage system is relatively low, the target protection strategy is determined to be controlling the energy storage system to reduce operating power, and this target protection strategy is executed.

In the aforementioned embodiment, a target protection strategy corresponding to the insulation information of the energy storage system is executed. The technical solution of the embodiments of the present application executes protection measures in the case where an insulation fault exists in the energy storage system, which can improve the safety and stability of the energy storage system and ensure the safety of operating personnel.

According to some embodiments of the present application, an insulation detection method for an energy storage system is provided. Taking the method being applied to the master controller of the energy storage system shown in FIG. 1 as an example for illustration, the method may include the following steps:
Step 1: before the energy storage system is powered on at high voltage, controlling an insulation detection circuit corresponding to each of battery clusters to perform insulation detection to obtain an insulation resistance value of each of the battery clusters.
Step 2: for each of the battery clusters, searching, from a plurality of candidate fault intervals, for a target fault interval matching the insulation resistance value of the battery cluster; determining, in a case where the target fault interval is found, the insulation information of the battery cluster according to the fault level corresponding to the target fault interval; or determining, in a case where the target fault interval is not found, that the battery cluster has no insulation fault.
Step 3: determining insulation information of the energy storage system according to the insulation information of all battery clusters in the energy storage system.
Step 4: in a stage where the energy storage system is powered on at high voltage, controlling the insulation detection circuit corresponding to each of the battery clusters to be turned off, and stopping insulation detection.
Step 5: after the energy storage system is powered on at high voltage, controlling the insulation detection circuit corresponding to each of the battery clusters in a time-sharing manner to perform insulation detection to obtain the insulation resistance value of each of the battery clusters.

Here, after the energy storage system is powered on at high voltage, if a target battery cluster among a plurality of battery clusters is faulty, a state of the insulation detection circuit corresponding to the target battery cluster is acquired; in a case where the insulation detection circuit corresponding to the target battery cluster is in an off state, the target battery cluster is controlled to be powered off at high voltage, and the insulation detection circuit corresponding to the target battery cluster is controlled to be turned on and insulation detection is performed to obtain the insulation resistance value of the target battery cluster; or in a case where the insulation detection circuit corresponding to the target battery cluster is in an on state, the insulation detection circuit corresponding to the target battery cluster is controlled in a time-sharing manner to perform insulation detection to obtain the insulation resistance value of the target battery cluster.

Step 6: for each of the battery clusters, searching, from a plurality of candidate fault intervals, for a target fault interval matching the insulation resistance value of the battery cluster; determining, in a case where the target fault interval is found, the insulation information of the battery cluster according to the fault level corresponding to the target fault interval; or determining, in a case where the target fault interval is not found, that the battery cluster has no insulation fault.

Step 7: determining insulation information of the energy storage system according to the insulation information of at least one of the battery clusters that has been powered on.

Step 8: executing a target protection strategy corresponding to the insulation information of the energy storage system.

Here, the target protection strategy includes at least one of controlling all battery clusters in the energy storage system to execute a high-voltage power-off operation, and controlling the energy storage system to reduce operating power.

Step 9: after the energy storage system is powered off at high voltage, determining the insulation information of the energy storage system according to insulation information of all battery clusters in the energy storage system.

Step 10: executing a target protection strategy corresponding to the insulation information of the energy storage system.

In the aforementioned embodiment, insulation detection is performed on the energy storage system in different stages. Especially after the energy storage system is powered on at high voltage, controlling the insulation detection circuit corresponding to each of the battery clusters in the energy storage system in a time-sharing manner to perform insulation detection can accurately determine the insulation resistance values, thereby accurately determining the insulation information of each of the battery clusters and the insulation information of the energy storage system, which consequently improves the safety and stability of the energy storage system and ensures the safety of operating personnel.

It should be understood that although the steps in the aforementioned flowcharts are shown sequentially as indicated by the arrows, these steps are not necessarily performed sequentially in the order indicated by the arrows. Unless there is a clear description here, the execution of these steps is not strictly limited in sequence, and these steps can be executed in other sequences. Moreover, at least a part of steps in the aforementioned flowcharts may include a plurality of steps or a plurality of stages, which are not necessarily executed and completed at the same moment but can be executed at different moments, and the execution sequence of these steps or these stages is not necessarily carried out in sequence but may be alternately or alternately executed with other steps of at least a part of steps or stages in other steps.

Based on the same inventive concept, embodiments of the present application further provide an insulation detection apparatus for an energy storage system, which is configured to implement the insulation detection method for an energy storage system described above. The problem-solving implementation provided by this apparatus is similar to the implementation recorded in the aforementioned method. Therefore, for the specific definitions in one or more embodiments of the insulation detection apparatus for an energy storage system provided below, reference may be made to the definitions for the insulation detection method for an energy storage system described above, which will not be repeated here.

Various modules in the aforementioned insulation detection apparatus for an energy storage system may be implemented entirely or partially by software, hardware, and a combination thereof. The aforementioned modules may be built in or independent of a processor of an electronic device in a form of hardware, or may be stored in a memory of the electronic device in a form of software, for the processor to invoke to execute operations corresponding to the foregoing modules.

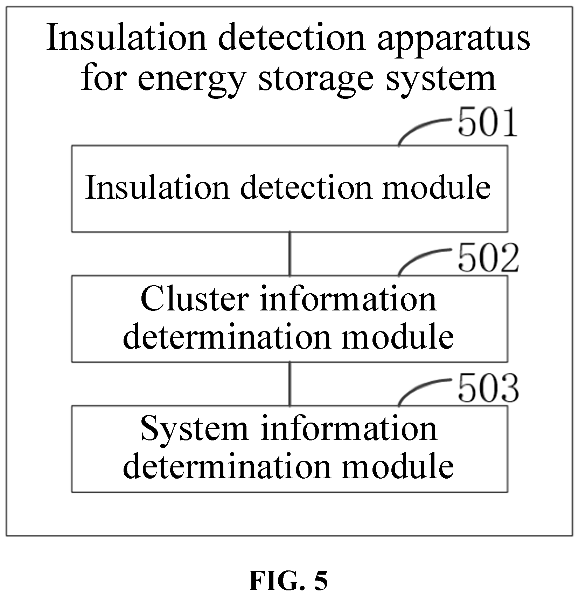

According to some embodiments of the present application, referring to FIG. 5, an insulation detection apparatus for an energy storage system is provided. The apparatus includes:
an insulation detection module 501 configured to acquire an insulation resistance value of each of battery clusters in the energy storage system;
a cluster information determination module 502 configured to determine insulation information of the battery cluster according to the insulation resistance value of the battery cluster, the insulation information including whether an insulation fault exists and, in a case where an insulation fault exists, a fault level; and
a system information determination module 503 configured to determine insulation information of the energy storage system according to the insulation information of the battery clusters.

In some embodiments, the cluster information determination module 502 is specifically configured to: search, from a plurality of candidate fault intervals, for a target fault interval matching the insulation resistance value of the battery cluster; determine, in a case where the target fault interval is found, the insulation information of the battery cluster according to the fault level corresponding to the target fault interval.

In some embodiments, the cluster information determination module 502 is further configured to: determine, in a case where the target fault interval is not found, that the battery cluster has no insulation fault.

In some embodiments, the system information determination module 503 is specifically configured to: determine the insulation information of the energy storage system according to a stage in which the energy storage system is located and the insulation information of at least one of the battery clusters.

In some embodiments, the system information determination module 503 is specifically configured to: determine, after the energy storage system is powered on at high voltage, the insulation information of the energy storage system according to the insulation information of at least one of the battery clusters that has been powered on; and determine, after the energy storage system is powered off at high voltage, the insulation information of the energy storage system according to the insulation information of all battery clusters in the energy storage system.

In some embodiments, the insulation detection module 501 is specifically configured to: control, after the energy storage system is powered on at high voltage, an insulation detection circuit corresponding to each of the battery clusters in a time-sharing manner to perform insulation detection to obtain the insulation resistance value of each of the battery clusters.

In some embodiments, the insulation detection module 501 is specifically configured to: after the energy storage system is powered on at high voltage, if a target battery cluster among a plurality of battery clusters is faulty, acquire a state of the insulation detection circuit corresponding to the target battery cluster; in a case where the insulation detection circuit corresponding to the target battery cluster is in an off state, control the target battery cluster to be powered off at high voltage, and control the insulation detection circuit corresponding to the target battery cluster to be turned on and perform insulation detection to obtain the insulation resistance value of the target battery cluster; or in a case where the insulation detection circuit corresponding to the target battery cluster is in an on state, control the insulation detection circuit corresponding to the target battery cluster in a time-sharing manner to perform insulation detection to obtain the insulation resistance value of the target battery cluster.

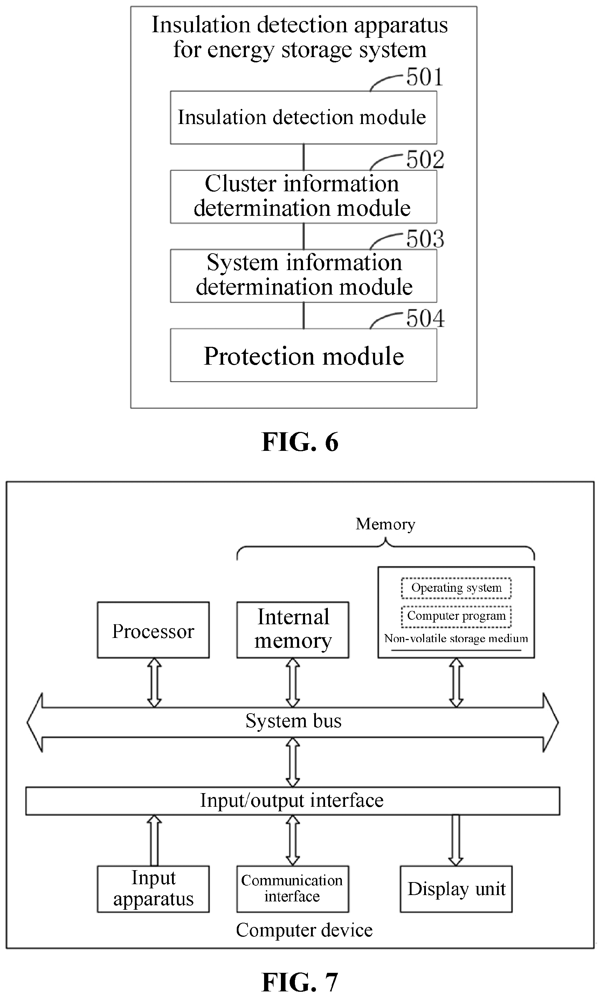

In some embodiments, referring to FIG. 6, the apparatus further includes:
a protection module 504 configured to execute a target protection strategy corresponding to the insulation information of the energy storage system, where the target protection strategy includes at least one of controlling all battery clusters in the energy storage system to execute a high-voltage power-off operation, and controlling the energy storage system to reduce operating power.

According to some embodiments of the present application, a computer device is provided. The computer device may be a master controller, and its internal structural diagram may be as shown in FIG. 7. The computer device includes a processor, a memory, an input/output interface, a communication interface, a display unit, and an input apparatus. Here, the processor, the memory, and the input/output interface are connected via a system bus. The communication interface, the display unit, and the input apparatus are connected to the system bus via the input/output interface. The processor of the computer device is configured to provide computing and control capabilities. The memory of the computer device includes a non-volatile storage medium and an internal memory. The non-volatile storage medium stores an operating system and a computer program. The internal memory provides an environment for the execution of the operating system and the computer program in the non-volatile storage medium. The input/output interface of the computer device is configured to exchange information between the processor and external devices. The communication interface of the computer device is configured for wired or wireless communication with an external terminal. The wireless communication can be realized by WIFI, a mobile cellular network, Near Field Communication (NFC) or other technologies. The computer program, when executed by the processor, implements an insulation detection method for an energy storage system. The display unit of the computer device is configured to form visually viewable images, which may be a display screen, a projection apparatus, or a virtual reality imaging apparatus. The display screen may be a liquid crystal display screen or an electronic ink display screen. The input apparatus of the computer device may be a touch layer covering the display screen, or may be a key, a trackball, or a touchpad disposed on a housing of the terminal, or may be an external keyboard, a touchpad, a mouse, or the like.

Those skilled in the art can understand that the structure shown in Fig. 7 is only a block diagram of a partial structure relevant to the solution of the present application, and does not constitute a limitation on the computer device to which the solution of the present application is applied. A specific computer device may include more or fewer components than those shown in the figures, or combine certain components, or have a different arrangement of components.

According to some embodiments of the present application, a non-transitory computer-readable storage medium including instructions is further provided, for example, a memory including instructions, where the aforementioned instructions can be executed by a processor of an electronic device to complete the aforementioned method. For example, the non-transitory computer-readable storage medium may be a read-only memory (ROM), a random access memory (RAM), a compact disc-ROM (CD-ROM), a magnetic tape, a floppy disk, an optical data storage device, or the like.

According to some embodiments of the present application, a computer program product is further provided, where the computer program, when executed by a processor, can implement the aforementioned method. The computer program product includes one or more computer instructions. When these computer instructions are loaded and executed on a computer, the processes or functions described in the embodiments corresponding to FIGS. 2 to 4 can be implemented, wholly or partially, thereby achieving part or all of the aforementioned method.

Those of ordinary skill in the art can understand that all or part of the process in the method of the embodiments corresponding to FIGS. 2 to 4 can be implemented by instructing the relevant hardware through a computer program. The computer program can be stored in a non-volatile computer-readable storage medium. When the computer program is executed, the processes of the examples of the above methods may be included. Any reference to a memory, a database or other media used in the various examples provided in the present application may include at least one of a non-volatile memory and a volatile memory. The non-volatile memory may include a Read-Only Memory (ROM), a magnetic tape, a floppy disk, a flash memory, an optical memory, a high-density embedded non-volatile memory, a Resistive Random Access Memory (ReRAM), a Magnetoresistive Random Access Memory (MRAM), a Ferroelectric Random Access Memory (FRAM), a Phase Change Memory (PCM), a graphene memory, or the like. The volatile memory may include a Random Access Memory (RAM), an external cache memory, or the like. By way of illustration instead of limitation, the RAM is available in a variety of forms, such as a Static Random Access Memory (SRAM), a Dynamic Random Access Memory (DRAM), or the like. The database involved in the various examples provided in the present application may include at least one of a relational database and a non-relational database. The non-relational database may include a blockchain-based distributed database, and the like, but is not limited thereto. The processor involved in the various examples provided in the present application may be a general-purpose processor, a central processing unit, a graphics processor, a digital signal processor, a programmable logic device, a data processing logic devices based on quantum computing, and the like, but is not limited thereto.

The technical features of the embodiments described above can be combined arbitrarily. In order to make the description concise, not all possible combinations of the technical features in the aforementioned embodiments are described. However, all the combinations of the technical features should be considered as falling within the scope described in this specification provided that they do not conflict with each other.

The above embodiments only describe several implementations of the present application for a specific and detailed understanding of the technical solution of the present application, but should not be construed as a limitation to the protection scope of the patent of the present invention. It should be noted that those of ordinary skill in the art may further make some variations and improvements without departing from the concept of the present application, all of which fall within the scope of protection of the present application. It should be understood that the technical solutions obtained by those skilled in the art through logical analysis, reasoning or limited experiments on the basis of the technical solutions provided in the present application are all within the protection scope of the attached claims described in the present application. Therefore, the scope of protection of the patent of the present application should be determined by the appended claims, and the specification and drawings can be used to explain the content of the claims.

## Claims

1. An insulation detection method for an energy storage system, comprising:
acquiring an insulation resistance value of each of battery clusters in the energy storage system;
determining insulation information of the battery cluster according to the insulation resistance value of the battery cluster, the insulation information comprising whether an insulation fault exists and, in a case where an insulation fault exists, a fault level of the battery cluster; and
determining insulation information of the energy storage system according to the insulation information of the battery clusters.

2. The method according to claim 1, wherein the determining insulation information of each of the battery clusters according to the insulation resistance value of each of the battery clusters comprises:
searching, from a plurality of candidate fault intervals, for a target fault interval matching the insulation resistance value of the battery cluster; and
determining, in a case where the target fault interval is found, the insulation information of the battery cluster according to the fault level corresponding to the target fault interval.

3. The method according to claim 2, further comprising:
determining, in a case where the target fault interval is not found, that the battery cluster has no insulation fault.

4. The method according to claim 1, wherein the determining insulation information of the energy storage system according to the insulation information of the battery clusters comprises:
determining the insulation information of the energy storage system according to a stage in which the energy storage system is located and the insulation information of at least one of the battery clusters.

5. The method according to claim 4, wherein the determining the insulation information of the energy storage system according to a stage in which the energy storage system is located and the insulation information of at least one of the battery clusters comprises:
determining, after the energy storage system is powered on at high voltage, the insulation information of the energy storage system according to the insulation information of at least one of the battery clusters that has been powered on; and
determining, after the energy storage system is powered off at high voltage, the insulation information of the energy storage system according to the insulation information of all battery clusters in the energy storage system.

6. The method according to claim 1, wherein the acquiring an insulation resistance value of each of battery clusters in the energy storage system comprises:
controlling, after the energy storage system is powered on at high voltage, an insulation detection circuit corresponding to the battery cluster in a time-sharing manner to perform insulation detection to obtain the insulation resistance value of the battery cluster.

7. The method according to claim 1, wherein the acquiring an insulation resistance value of each of battery clusters in the energy storage system comprises:
after the energy storage system is powered on at high voltage, if a target battery cluster among a plurality of battery clusters is faulty, acquiring a state of the insulation detection circuit corresponding to the target battery cluster;
in a case where the insulation detection circuit corresponding to the target battery cluster is in an off state, controlling the target battery cluster to be powered off at high voltage, and controlling the insulation detection circuit corresponding to the target battery cluster to be turned on and perform insulation detection to obtain the insulation resistance value of the target battery cluster; or
in a case where the insulation detection circuit corresponding to the target battery cluster is in an on state, controlling the insulation detection circuit corresponding to the target battery cluster in a time-sharing manner to perform insulation detection to obtain the insulation resistance value of the target battery cluster.

8. The method according to any one of claims 1 to 7, further comprising:
executing a target protection strategy corresponding to the insulation information of the energy storage system, wherein the target protection strategy comprises at least one of controlling all battery clusters in the energy storage system to execute a high-voltage power-off operation, and controlling the energy storage system to reduce operating power.

9. An insulation detection apparatus for an energy storage system, comprising:
an insulation detection module configured to acquire an insulation resistance value of each of battery clusters in the energy storage system;
a cluster information determination module configured to determine insulation information of each of the battery clusters according to the insulation resistance value of each of the battery clusters, the insulation information comprising whether an insulation fault exists and, in a case where an insulation fault exists, a fault level of the battery cluster; and
a system information determination module configured to determine insulation information of the energy storage system according to the insulation information of the battery clusters.

10. A computer device comprising a memory and a processor, the memory storing a computer program, wherein the computer program, when executed by the processor, implements the method according to any one of claims 1 to 8.

11. A computer-readable storage medium having a computer program stored thereon, wherein the computer program, when executed by a processor, implements the method according to any one of claims 1 to 8.

12. A computer program product comprising a computer program, wherein the computer program, when executed by a processor, implements the method according to any one of claims 1 to 8.
